# EUROPEAN PATENT SPECIFICATION

(11) **EP 2 918 956 B1**
(45) Date of publication and mention of the grant of the patent: **14.06.2017**
(21) Application number: 15158904.1
(22) Date of filing: 12.03.2015
(51) Int. Cl.: F25D 29/00, F25D 31/00

(54) **COOLING AND/OR HEATING EQUIPMENT**
KÜHL- UND/ODER HEIZANLAGE
ÉQUIPEMENT DE CHAUFFAGE ET/OU DE REFROIDISSEMENT

(30) Priority: 12.03.2014 PT 10750514
(43) Date of publication of application: 16.09.2015
(73) Proprietor: Martins & Azevedo, Lda., 4485-613 Modivas (PT)
(72) Inventor: Martins Azevedo, Armando, 4465-741 Leca Do Balio (PT)
(74) Representative: Silvestre de Almeida Ferreira, Luís Humberto

(56) References cited:
- WO-A1-02/065036
- WO-A1-2014/034434
- DE-U1-202006 009 543
- US-A1- 2013 067 375

## Description

### Technical field

This document refers to a cooling and/or heating equipment, in particular a wine cellar equipment, wherein the respective control device is in the cooling/heating cabinet allowing the configuration thereof when the equipment's door is either closed or opened.

### Background

The use of electronic systems for controlling and monitoring cooling and/or heating systems has been increasingly replacing the conventional mechanical control and supervisory systems, such as for example bimetal thermostats and traditional thermometers.

In an attempt to facilitate and simplify the use of equipment for the end user, a progressive use of Liquid Crystal Displays (LCD) and single contact buttons systems by manufacturers is observed. These allow the user to easily interact with the devices and either change the operation thereof or turn on or off available features.

In recent years, widespread electronic equipment with user interaction via touch has increased both production of and demand for devices with touch functionality. Touch-controlled equipment has thus been increasingly developed and commercialized, such as is for example disclosed in WO02/065036 , US2013/067375 and WO2014/034434.

AWC460DZ product by Avallon is a cooling device comprising a control device with direct touch buttons. This device is isolated inside the equipment, which precludes interaction therewith even when the door is closed.

CWF340DZ product by EdgeStart is a cooling device comprising a device integrated within the door, which is connected to the main body of the equipment by means of connecting cables near the hinges. This approach has serious drawbacks in maintenance and repair situations since all connecting cables between the device and remainder elements must be placed near the hinges holding said door. Closing and opening the door causes inevitable wear, leading the equipment to necessary repair short time after.

### General description

Aiming at not only solving the problems mentioned above but also eliminating deficiencies related to the above solutions, the development of a cooling/heating device has become necessary, which could control the temperature and conditions inside the equipment through the door (in open and closed positions) while avoiding maintenance problems caused by door electrification, that is, early wear of electrical cables responsible for the electrification of the door.

A cooling, heating or cooling and heating equipment is disclosed, for preserving beverages, food or biological matter, characterised by comprising:
a cooling system and/or a heating system;
a dielectric door; and
a control device comprising one or more capacitive sensing elements for detecting the touch by the equipment's user; one or more physical sensors for quantifying equipment-related physical parameters; an electronic circuit for reading the capacitive sensing elements and controlling the equipment; and detecting means for detecting whether the door is open or closed;
wherein the capacitive sensing element or elements are arranged to directly detect the touch of the user when the door is open, and are arranged to detect the touch of the user through the dielectric door when the door is closed; and
wherein the control device is configured to calibrate the detection threshold value of touch in the capacitive sensing elements depending on whether the door is open or closed.

In an embodiment, the control device is configured to calibrate the detection threshold value of touch in the capacitive sensing elements:
at initial startup of the control circuit; and
when there is a change in electric capacitance in two or more capacitive sensing elements.

In an embodiment, the control device is configured to:
calibrate the reference capacitance of the capacitive sensing elements and the detection threshold value of touch in the capacitive sensing elements: at initial startup of the control circuit; and when there is a change in the electric capacitance in two or more capacitive sensing elements; and
execute a routine relating to a selected button upon change in electric capacitance on a single capacitive sensing element, which is the capacitive sensing element corresponding to the selected button.

In an embodiment, the capacitive sensing elements are electrodes that are flexible to establish direct contact in compression with the dielectric door when the latter is in closed position.

In an embodiment, the flexible electrodes are springs.

In an embodiment, the control device is configured to select a different routine to be executed regarding a selected button depending on whether the door is open or closed.

In an embodiment, the physical sensors comprise a sensor for measuring temperature and humidity.

In an embodiment, the equipment comprises an injected plastic structure for supporting the control device comprising three distinct regions:
a region to accommodate the user interface;
a region to accommodate the capacitive sensing elements for interaction and control; and
an surrounding region for fixation and ventilation of all electronic components for accommodation on top of the main body of the equipment.

In an embodiment, the electronic circuit comprises a control circuit for data processing, interpreting and programming the reading circuit, and controlling the actuating elements of the cooling and/or heating equipment; and a reading circuit for reading electrical signals from the capacitive sensing elements and sending the respective data for subsequent processing.

A method for operating a cooling, heating or cooling and heating equipment is further disclosed, for preserving beverages, food or biological matter, the equipment comprising:
a cooling system and/or a heating system;
a dielectric door; and
a control device comprising one or more capacitive sensing elements for detecting a touch by the equipment's user; one or more physical sensors for quantifying equipment-related physical parameters; an electronic circuit for reading the capacitive sensing elements and controlling the equipment; and detecting means for detecting whether the door is open or closed;
wherein the capacitive sensing element or elements are arranged to directly detect the touch of the user when the door is open, and are arranged to detect the touch of the user through the dielectric door when the door is closed; and wherein the method comprises calibrating the detection threshold value of touch in the capacitive sensing elements depending on whether the door is open or closed.

In an embodiment, the method comprises calibrating the detection threshold value of touch in the capacitive sensing elements:
at initial startup of the control circuit; and
when there is a change in electric capacitance in two or more capacitive sensing elements.

In an embodiment, the method comprises:
calibrating the reference capacitance of the capacitive sensing elements and the detection threshold value of touch in the capacitive sensing elements: at initial startup of the control circuit; and when there is a change in electric capacitance in two or more capacitive sensing elements; and
executing a routine relating to a selected button upon change in electric capacitance in a single capacitive sensing element, which is the capacitive sensing element corresponding to the selected button.

In an embodiment, the method comprises selecting a different routine to be executed regarding a selected button depending on whether the door is open or closed.

In an embodiment, the equipment is a wine cellar.

In the present document, a cooling and/or heating equipment is further disclosed comprising:
- a cooling system and/or a heating system;
- a dielectric door; and
- a control device comprising:
- one or more capacitive sensing elements;
- one or more physical sensors; and
- an electronic circuit.

In an embodiment, the electronic circuit comprises a control circuit and a reading circuit.

In another embodiment, the capacitive sensing elements comprise flexible electrodes. In yet another embodiment, the flexible electrodes are springs.

In an embodiment the physical sensor comprises the measurement of:
- temperature; and
- humidity.

In another embodiment, the cooling system comprises an evaporator with different distribution densities in at least two regions of the equipment.

The present application also discloses a method for performing a control circuit of the cooling and/or heating equipment comprising the steps of:
- calibrating the reference electric capacitance;
- defining the detection threshold;
- verifying changes in electric capacitance measured in at least one of the capacitive sensing elements;
- verifying whether the changes occur in at least two capacitive sensing elements;
- verifying whether the changes occur in only one capacitive sensing element; and
- executing the routine regarding the capacitive sensing element selected by the user.

In an embodiment, the step of calibrating the reference electric capacitance occurs:
- at initial startup of the control circuit; and
- when changes observed regard a plurality of capacitive sensing elements.

In yet another embodiment, the step of calibrating the reference electric capacitance comprises sending a calibration message from the control circuit to the reading circuit.

In yet another embodiment, the step of verifying changes in electric capacitance occurs when:
- there are no changes in the electric capacitance measured;
- there are no changes in capacitance in only one capacitive sensing element; or
- when a routine regarding one capacitive sensing element selected by the user is performed.

This solution also discloses the use of the equipment in preservation of beverages, food or biological matter; in particular wine cellars.

This solution arises from the need to interact with a cooling and/or heating equipment when its door is closed, wherein the control device thereof is sealed by said door.

Said control device aims at providing the user with not only an interaction means for obtaining information but also an actuating means on the cooling and/or heating equipment. From the user's perspective, the device is positioned behind said door when it is closed. This arrangement allows the user to interact with the control device in two different positions of the door: the open door situation, wherein the user has direct physical contact with the device; and the closed door situation, normal operation situation, wherein the user has direct physical contact with the door, specifically in the region of the door placed directly intermediate between the device and the user.

The control device comprises:
- physical sensors for quantifying in electrical signals equipment-related physical parameters;
- capacitive sensing elements for the detection of user touch instructions;
- a reading circuit for reading electrical signals from capacitive sensing elements and sending the respective data for subsequent processing; and
- a control circuit for data processing, interpreting and programming the reading circuit, and controlling the actuating elements of the cooling and/or heating equipment.

So that the control device can read and receive user interactions in both door positions, the capacitive sensing elements perceive use interactions both directly and in the presence of an intermediate dielectric means. In either situations, an automatic adjustment process is required when physical conditions change.

In order to perceive user interactions with the control device, the electrodes on the capacitive sensing elements perform a function equivalent to an electronic capacitor armature, the electrical load on the finger of the user being, for example, the corresponding armature.

The capacitive sensing elements comprise flexible electrodes that establish direct contact with the dielectric door when the latter is in closed position. These are arranged so that the contact surface of the electrode moves between a balanced position and a compression position. The compression on the electrodes is applied by the dielectric door of the cooling and/or heating equipment when in the closed position.

When the equipment's door is open, the electrodes retrieve their shape until balanced position, and the reference electric capacitance necessary to perceive user activity is activated. If the door is closed, the electrodes are compressed and reading of electric capacitance is performed on the dielectric material, which involves a higher reference electric capacitance than that of an opposed scenario.

The physical flexibility of the electrodes ensures that they are in direct physical contact with the dielectric door when it is closed. Otherwise, there would be the need to ensure that the electrodes were finely aligned and that physical contact was always established with the door lock, which would make the equipment's manufacture highly difficult. This helps decreasing error and further decreases maintenance requirements.

State transition thus allows identifying the current operating state, that is, whether the dielectric door is open or closed. Being so, capacitive sensing elements make a structural arrangement with the dual function of both recognizing user activity and also identifying the current operating state possible.

The user interacts and controls the cooling and/or heating equipment, wherein accessible actions to the user may be selected and made available, by the control device, based on the knowledge of the current position of the dielectric door. The user of the cooling and/or heating equipment is thus aided by the control device, which provides a set of timely and appropriate actions for each different situation.

The present document allows the entire electronic responsible for controlling a cooling and/or heating equipment, such as the reading circuit, control circuit, physical sensors, and capacitive sensing elements, to be arranged in a unique place, not only optimizing the manufacturing process of the cooling and/or heating equipment, but also facilitating future technical interventions.

### Brief description of the drawings

For an easier understanding of the art, drawings are herein attached, which represent preferred embodiments which, however, are not intended to limit the scope of the present invention.
Figure 1 shows in exploded view an upper position with the several elements separated on top of the cooling and/or heating equipment, wherein reference numbers represent:
   1 - control circuit;
   2 - reading circuit;
   3 - supporting structure;
   4 - dielectric door.
Figure 2 shows a side view of the top of the cooling and/or heating equipment, wherein reference numbers represent:
   1 - control circuit;
   2 - reading circuit;
   3 - supporting structure;
   4 - dielectric door;
Figure 3 shows a side view of the top of the cooling and/or heating equipment, wherein reference numbers represent:
   2 - reading circuit; and
   4 - dielectric door.
Figure 4 shows a side view of the top of the cooling and/or heating equipment with the door in open position, wherein reference numbers represent:
   2 - reading circuit;
   3 - supporting structure; and
   4 - dielectric door.
Figure 5 shows an overview of the cooling and/or heating equipment with the door in closed position, wherein reference numbers represent:
   4 - dielectric door.
Figure 6 shows an overview of the cooling and/or heating equipment with the door in closed position, wherein reference numbers represent:
   4 - dielectric door.
Figure 7 shows the operating principle of the capacitive sensing elements used.
Figure 8 shows the operating mode of the base system for capacitive field variation detection.
Figure 9 shows the operating scenarios on open and closed door situations, and the transition between the two.
Figure 10 shows an operational flowchart of the calibration and detection systems used.

### Detailed description

The present document describes a cooling and/or heating equipment controlled by a control device. In an embodiment, the control device can be implemented for controlling a cooling and/or heating equipment for wine bottles. It may also be used for preserving other goods.

In an embodiment, a cooling and/or heating equipment comprises:
- a cooling system which, in an embodiment, comprises an evaporator for cooling thereof;
- a heating system for ensuring that internal temperature does not drop below the set value;
- a control device which, in an embodiment, comprises a first board supporting a display, preferably of liquid crystal and touch buttons, a second board, a power supply and control board, the interconnection between both boards and interfaces with physical sensors; and
- a door for the cooling and/or heating equipment, composed of a dielectric material, which, upon closing, ensures the latter is heat sealed, such as a glass door.

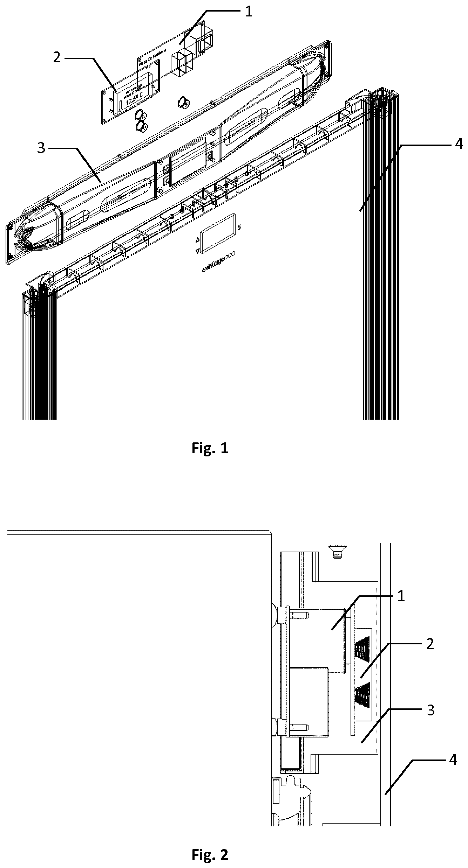

Figure 1 shows the main elements of the control device fitted on top of an equipment and the door composed of a dielectric material, such as glass. In addition to both boards comprised by the control device and outer door, a supporting structure in polymer material is also illustrated.

From the user's perspective, the control device is positioned behind the door when it is in closed position. The interaction with the control device is possible in two different positions of the door: the open door situation, as shown in Figure 2, wherein the user has direct physical contact with the device; and the closed door situation, normal operating situation, wherein the user has direct physical contact with the door, specifically in the region of the door directly intermediate between the device and the user.

The device thus becomes accessible at any position of the outer door.

The control device comprises:
- physical sensors, such as a thermometer or a humidity meter inside the equipment.
- capacitive sensing elements with flexible electrodes such as signal transmission/lead springs ref.MS0035 Airedale Springs selected under the mechanical requirements of the control device;
- reading electronic circuit, such as QT1070 QTouch integrated circuit produced *by Atmel;* and
- an electronic control circuit, such as PIC18F26K22 circuit produced by Microchip.

As further note, the integrated circuit, in particular QT1070 QTouch by Atmel has two distinct operating modes:
a) stand-alone mode: in which it operates in autonomous mode and enables activating/deactivating an output as the variation (reading) on the electric capacitance input is changed, and has an automatic initial calibration;
b) microcontroller mode: in this mode, the system communicates to an external microcontroller, with communication standard 12C (Inter-Integrated Circuit), all read field values and the external processing unit is to process said data and perform the actions scheduled based on the received/reported data.

The mode used may be b) wherein all data processing and resulting actions are performed based on a specific/proprietary program developed and executed in the microcontroller, for example, said PIC18F26K22. The user interacts with and controls the cooling and/or heating equipment and is able, for example, to set a target temperature, turn the inner lighting on or off, among other features. The actions the user has access to may also be selected and made available by the control device, based on knowledge of the current position of the outer door. The user of the cooling and/or heating equipment is thus aided by the control device, which provides a set of timely and appropriate actions for each different situation.

In a preferred embodiment, once the control device is mounted, the cooling and/or heating equipment has the arrangement shown in Figures 2, 4 and 6 with the outer door open. In this scenario, the user can access the inside of the cooling and/or heating equipment, and may also interact in direct physical contact with the capacitive sensing elements.

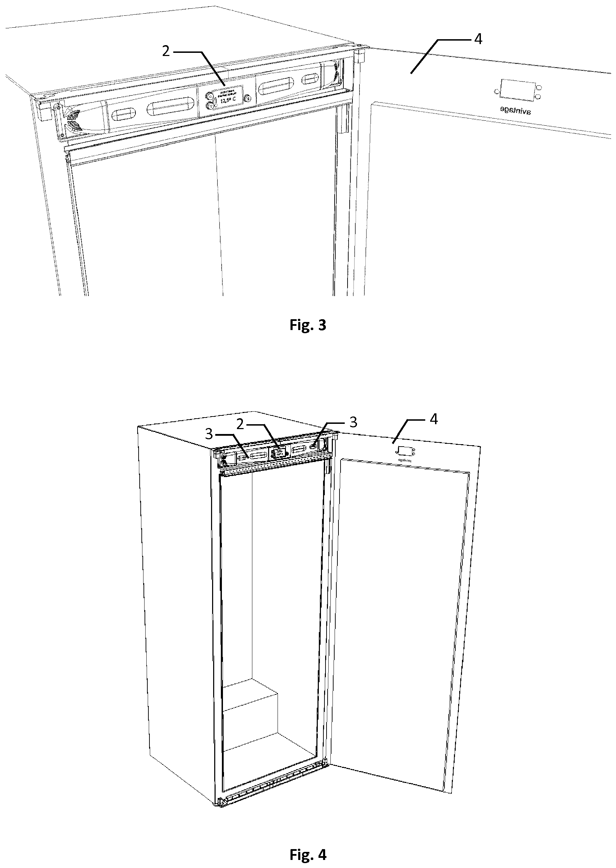

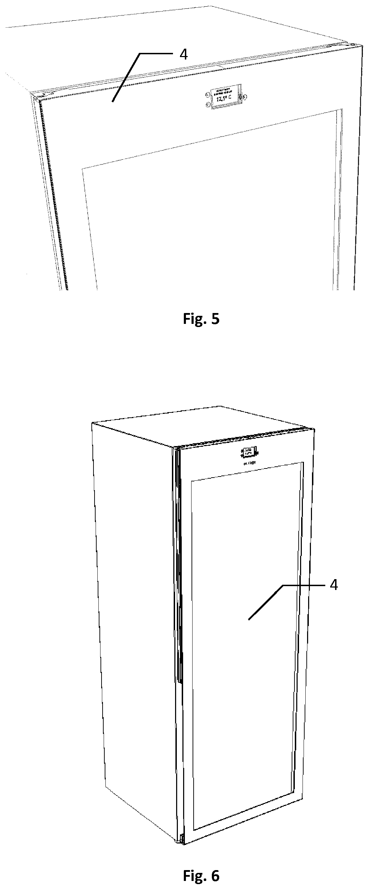

When the outer door is in the closed position, the electrodes of the capacitive sensing elements are accessible as shown in Figure 5. Additionally, Figure 3 shows a side view of the capacitive sensing elements when the door is closed.

In this position of the door, the control device can be used through contact with the dielectric material, i.e., the user makes direct physical contact with the door, specifically in the region of the door placed directly intermediate between the device and the user. Figure 5 also shows that only the liquid crystal display is directly accessible. Said display could also be arranged behind the glass door, since the intermediate material is transparent.

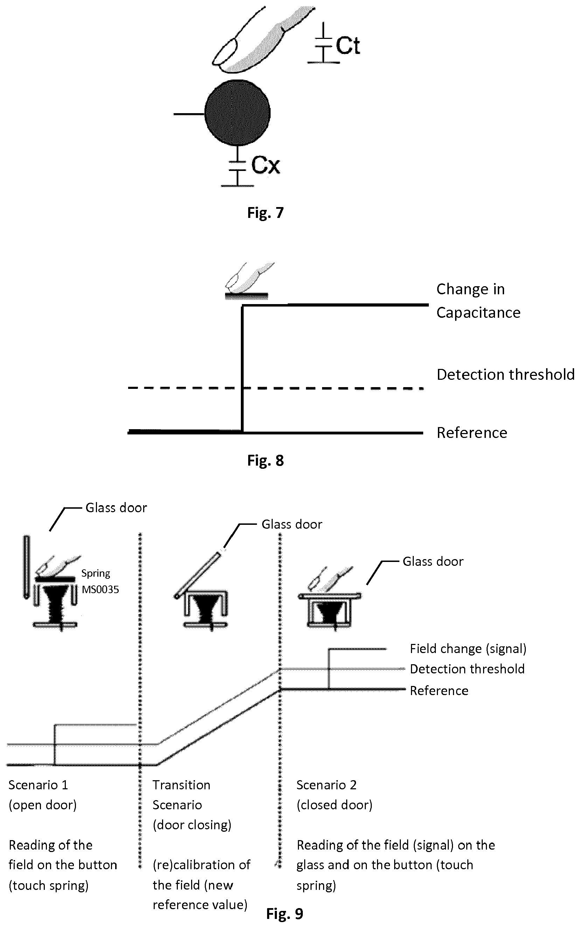

In order to perceive user interactions with the control device, the electrodes on the capacitive sensing elements perform a function equivalent to an electronic capacitor armature, as shown in Figure 7, for example, the finger of the user being the corresponding armature. Figure 8 shows the several interaction thresholds with a capacitive sensing element.

Figure 9 shows the operating scenarios of capacitive sensing elements. When the outer door is open, the spring retrieves its shape until balanced position, and the electric capacitance necessary to perceive user activity is activated. If the door is closed, the spring is compressed and reading of electric capacitance is performed on the dielectric material, which involves a higher reference electric capacitance than that of an opposed scenario, since the user makes physical contact directly with the electrode in such scenario.

In an embodiment, the cooling and/or heating equipment further comprises an injected plastic structure supporting the control device having a parallelepiped shape and having three distinct regions:
- a central region to accommodate a user interface,
- a side region of said interface to accommodate capacitive sensing elements, which will allow the user to interact with and control the unit and an engagement region responsible for the fixation and which allows ventilating all electronic components housed on top of the cooling and/or heating equipment.

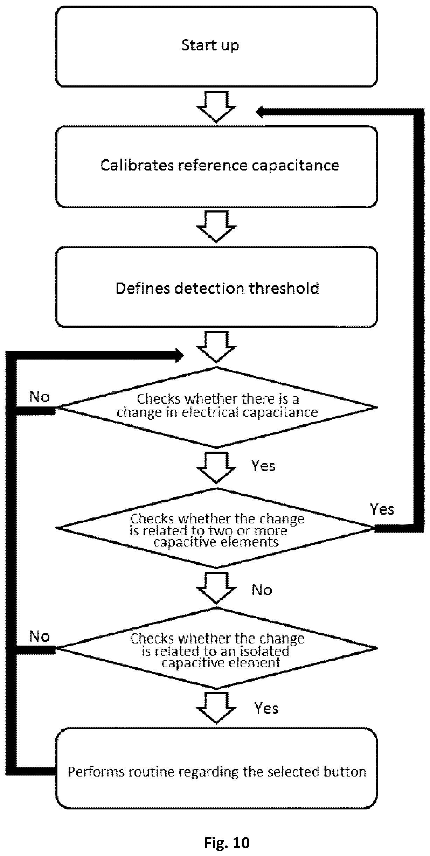

The operation of the control device may be carried out based on the diagram shown in Figure 10.

When the control circuit is started, a calibration message is sent instructing the reading circuit to check and adjust the reference electric capacitance value. The reference value is that that is measured by the reading circuit in normal state.

The detection threshold value, as shown in Figure 8, is the value from which the reading circuit detects a variation in electric capacitance within a capacitive sensing element, for example in the presence of a finger in proximity thereto.

Subsequently to starting-up the capacitive sensing elements, the device enters the main loop wherein the device checks at intervals whether changes in electric capacitance occur in at least one of the capacitive sensing elements.

If the change in electric capacitance occurs in at least two capacitive sensing elements, then it is assumed that the door is closed and an adjustment to new physical conditions shall be performed. If instead the change in electric capacitance occurs in only one capacitive sensing element, then the corresponding routine is performed. Thus, the system self-calibrates upon detecting that door changes from open to closed position, and vice versa.

The actions triggered on the control device depend on the system state, on the capacitive sensing element selected by the user and on the door position, i.e. open or closed position. That is, the same sensing element can trigger two different actions depending on whether the door is closed or open - e.g. turning off an alarm when the door is closed and turning on the light when the door is open.

The routines available based on the capacitive sensing element and system state are, for example, turning on the light, displaying set points or accessing the settings menu. This menu allows the user to increase or decrease the variable fields and also the set for saving and proceeding through the menu.

It should be noted that when the reference electric capacitance changes to a lower value, for example after opening the door and directly interacting with the capacitive sensing elements, the reading circuit has, in an embodiment, an automatic calibration function, there being no need for any type of detection/actuation.

The individual cooling system may comprise an evaporator arranged so as to create several regions with different temperatures inside the equipment, thus waiving from physical separation systems inside the equipment, from control mechanisms, either mechanical or electromechanical, from the evaporation system itself and from any kind of ventilation therein.

The present specification is, of course, in no way restricted to the embodiments herein described and a person of ordinary skill in the art will be able to provide many modification possibilities thereto and substitutions of technical features for equivalents, according to requirements in each situation, as defined in the claims.

The disclosed embodiments are combinable. The following claims set out particular embodiments of the invention.

## Claims

1. Cooling, heating or cooling and heating equipment, for preserving beverages, food or biological matter, **characterized by** comprising:
a cooling system and/or a heating system;
a dielectric door (4); and
a control device comprising one or more capacitive sensing elements for detecting the touch by the equipment's user; one or more physical sensors for quantifying equipment-related physical parameters; an electronic circuit (1) for reading the capacitive sensing elements and controlling the equipment; and detecting means for detecting whether the dielectric door (4) is open or closed;
wherein the capacitive sensing element or elements are arranged to directly detect the touch of the user when the dielectric door (4) is open, and are arranged to detect the touch of the user through the dielectric door (4) when the dielectric door (4) is closed; and
wherein the control device is configured to calibrate the detection threshold value of touch in the capacitive sensing elements depending on whether the dielectric door (4) is open or closed.

2. Equipment according to the previous claim wherein the control device is configured to calibrate the detection threshold value of touch in the capacitive sensing elements:
at initial startup of the control circuit (1); and
when there is a change in the electric capacitance in two or more capacitive sensing elements.

3. Equipment according to any previous claim wherein the control device is configured to:
calibrate the reference capacitance of the capacitive sensing elements and the detection threshold value of touch in the capacitive sensing elements: at initial startup of the control circuit (1); and when there is a change in the electric capacitance in two or more capacitive sensing elements; and
execute a routine relating to a selected button upon change in electric capacitance on a single capacitive sensing element, which is the capacitive sensing element corresponding to the selected button.

4. Equipment according to any previous claim, wherein the capacitive sensing elements are electrodes that are flexible to establish direct contact in compression with the dielectric door (4) when the latter is in the closed position.

5. Equipment according to the previous claim, wherein the flexible electrodes are springs.

6. Equipment according to any previous claim wherein the control device is configured to select a different routine to be executed regarding a selected button depending on whether the dielectric door (4) is open or closed.

7. Equipment according to any previous claim, wherein the physical sensors comprise a sensor for measuring temperature and humidity.

8. Equipment according to any previous claim comprising an injected plastic structure (3) for supporting the control device having a parallelepiped shape and comprising three distinct regions:
a central region to accommodate the user interface;
a side region of said interface to accommodate the capacitive sensing elements for interaction and control; and
a surrounding region for fixation and ventilation of all electronic components, for accommodation on top of the main body of the equipment.

9. Equipment according to any previous claim wherein the electronic circuit comprises a control circuit (1) for data processing, interpreting and programming the reading circuit, and controlling the actuating elements of the cooling and/or heating equipment; and a reading circuit for reading electrical signals from the capacitive sensing elements and sending the respective data for subsequent processing.

10. Equipment according to any previous claim wherein the equipment is a wine cellar.

11. Method for operating a cooling, heating or cooling and heating equipment, for preserving beverages, food or biological matter, wherein the equipment comprises:
a cooling system and/or a heating system;
a dielectric door (4); and
a control device comprising one or more capacitive sensing elements for detecting the touch by the equipment's user; one or more physical sensors for quantifying equipment-related physical parameters; an electronic circuit (1) for reading the capacitive sensing elements and controlling the equipment; and detecting means for detecting whether the dielectric door (4) is open or closed;
wherein the capacitive sensing element or elements are arranged to directly detect the touch of the user when the dielectric door (4) is open, and are arranged to detect the touch of the user through the dielectric door (4) when the dielectric door (4) is closed; **characterized in that** the method is further comprising calibrating the detection threshold value of touch in the capacitive sensing elements depending on whether the dielectric door (4) is open or closed.

12. Method according to the previous claim comprising calibrating the detection threshold value of touch in the capacitive sensing elements:
at initial startup of the control circuit (1); and
when there is a change in the electric capacitance in two or more capacitive sensing elements.

13. Method according to any of claims 11-12 comprising:
calibrating the reference capacitance of the capacitive sensing elements and the detection threshold value of touch in the capacitive sensing elements: at initial startup of the control circuit (1); and when there is a change in the electric capacitance in two or more capacitive sensing elements; and
executing a routine relating to a selected button upon change in the electric capacitance in a single capacitive sensing element, which is the capacitive sensing element corresponding to the selected button.

14. Method according to any previous claim comprising selecting a different routine to be executed regarding a selected button depending on whether the dielectric door (4) is open or closed.

15. Method according to any previous claim wherein the equipment is a wine cellar.

## Patentansprüche

1. Anlage zum Kühlen, Beheizen oder Kühlen und Beheizen, zum Konservieren von Getränken, Lebensmitteln oder organischem Material, **dadurch gekennzeichnet, dass** sie umfasst:
ein Kühlsystem und/oder ein Heizsystem;
eine dielektrische Tür (4); und
eine Steuereinheit umfassend ein oder mehrere kapazitive Sensorelemente zur Erfassung der Berührung durch den Benutzer der Anlage; einen oder mehrere physische Sensoren zur Bestimmung von mit der Anlage verbundenen physischen Parametern; einen elektronischen Schaltkreis (1) zum Lesen der kapazitiven Sensorelemente und Steuerung der Anlage; und Mittel zur Erfassung, ob die dielektrische Tür (4) geöffnet oder geschlossen ist; wobei das kapazitive Sensorelement oder die Elemente so angeordnet sind, dass sie die Berührung durch den Benutzer direkt erfassen, wenn die dielektrische Tür (4) geöffnet ist, und so angeordnet sind, dass die Berührung durch den Benutzer durch die dielektrische Tür (4) erfasst wird, wenn die dielektrische Tür (4) geschlossen ist; und
wobei die Steuereinheit so konfiguriert ist, dass sie die Erkennungsschwelle für die Berührung bei den kapazitiven Sensorelemente dementsprechend kalibriert, ob die dielektrische Tür (4) geöffnet oder geschlossen ist.

2. Anlage gemäß dem vorherigen Anspruch, wobei die Steuereinheit so konfiguriert ist, dass sie die Erkennungsschwelle für die Berührung bei den kapazitiven Sensorelemente kalibriert:
bei der ersten Inbetriebnahme der Steuereinheit (1); und
sobald eine Veränderung bei der elektronischen Kapazität eines oder mehrere kapazitiver Sensorelemente erfolgt.

3. Anlage gemäß einem der vorherigen Ansprüche, wobei die Steuereinheit so konfiguriert ist, dass:
sie die Referenzkapazität der kapazitiven Sensorelemente und die Erkennungsschwelle für die Berührung bei den kapazitiven Sensorelemente kalibriert: bei der ersten Inbetriebnahme der Steuereinheit (1);
und wenn es zu einer Änderung in der elektrischen Kapazität in zwei der mehr kapazitiven Sensorelemente kommt; und
bei der Änderung der elektrischen Kapazität eines einzelnen kapazitiven Sensorelements eine Routine in Bezug auf einen ausgewählten Knopf durchführt, wobei das kapazitive Sensorelement dem gewählten Knopf entspricht.

4. Anlage gemäß einem der vorherigen Ansprüche, wobei die kapazitiven Sensorelemente flexible Elektroden sind, die einen direkten Kontakt beim Drücken auf die dielektrische Tür (4) herstellen, wenn sich diese in der geschlossenen Position befindet.

5. Anlage gemäß dem vorherigen Anspruch, wobei die flexiblen Elektroden Federn sind.

6. Anlage gemäß einem der vorherigen Ansprüche wobei die Steuereinheit so konfiguriert ist, dass sie je nach gewähltem Knopf eine andere Routine ausführt, abhängig davon, ob die dielektrische Tür (4) geöffnet oder geschlossen ist.

7. Anlage gemäß einem der vorherigen Ansprüche, wobei die physikalischen Sensoren einen Sensor zur Messung der Temperatur und Feuchtigkeit umfassen.

8. Anlage gemäß einem der vorherigen Ansprüche, umfassend eine Struktur (3) aus gespritztem Kunststoff zur Aufnahme der Kontrolleinheit in Form einer Parallelepipedform und umfassend drei unterschiedliche Bereiche: einen zentralen Bereich zur Aufnahme der Benutzerschnittstelle;
ein seitlicher Bereich der genannten Schnittstelle zur Aufnahme der kapazitiven Sensorelemente für die Interaktion und Steuerung; und
einen umliegenden Bereich zur Befestigung und Belüftung aller elektronischen Komponenten, zum Gehäuse am Hauptteil der Anlage.

9. Anlage gemäß einem der vorherigen Ansprüche, wobei der elektronische Schaltkreis umfasst einem Steuereinheit (1)
für die Verarbeitung und Auswertung von Daten und die Programmierung der Leseschaltung, und zur Steuerung der Steuerelemente der Kühl- und/oder Heizanlage; und einer Leseschaltung für das Lesen der elektronischen Signale der kapazitiven Sensorelemente und Weiterleitung der entsprechenden Daten für die anschließende Verarbeitung.

10. Anlage gemäß einem der vorherigen Ansprüche,wobei die Anlage ein Weinkeller ist.

11. Verfahren für den Betrieb einer Anlage zum Kühlen, Beheizen oder Kühlen und Beheizen zum Konservieren von Getränken, Lebensmitteln oder organischem Material, wobei das Verfahren umfasst:
ein Kühlsystem und/oder ein Heizsystem;
eine dielektrischen Tür (4); und
eine Steuereinheit umfassend ein oder mehrere kapazitiven Sensorelemente zur Erfassung der Berührung durch den Benutzer der Anlage; einen oder mehrere physische Sensoren zur Bestimmung von mit der Anlage verbundenen physischen Parametern; einen elektronischen Schaltkreis (1) zum Lesen der kapazitiven Sensorelemente und Steuerung der Anlage; und Mittel zur Erfassung, ob die dielektrische Tür (4) geöffnet oder geschlossen ist; wobei das kapazitive Sensorelement oder die Elemente so angeordnet sind, dass sie die Berührung durch den Benutzer direkt erfassen, wenn die dielektrische Tür (4) geöffnet ist, und so angeordnet sind, dass die Berührung durch den Benutzer durch die dielektrische Tür (4) erfasst wird, wenn die dielektrische Tür (4) geschlossen ist;
**dadurch gekennzeichnet, dass** das Verfahren ferner umfasst, dass die Erkennungsschwelle für die Berührung bei den kapazitiven Sensorelemente dementsprechend kalibriert wird, ob die dielektrische Tür (4) geöffnet oder geschlossen ist.

12. Verfahren gemäß dem vorherigen Anspruch, umfassend die Kalibrierung der Erkennungsschwelle für die Berührung bei den kapazitiven Sensorelementen: bei der ersten Inbetriebnahme der Steuereinheit (1); und
sobald eine Veränderung bei der elektronischen Kapazität eines oder mehrere kapazitiver Sensorelemente erfolgt.

13. Verfahren gemäß einem der Ansprüche 11-12 umfassend: Kalibrierung der Referenzkapazität der kapazitiven Sensorelemente und der Erkennungsschwelle für die Berührung bei den kapazitiven Sensorelemente: bei der ersten Inbetriebnahme der Steuereinheit (1);
und sobald eine Veränderung bei der elektronischen Kapazität eines oder mehrere kapazitiver Sensorelemente erfolgt; und
bei der Änderung der elektrischen Kapazität eines einzelnen kapazitiven Sensorelements eine Routine in Bezug auf einen ausgewählten Knopf durchführt, wobei das kapazitive Sensorelement dem gewählten Knopf entspricht.

14. Verfahren gemäß einem der vorherigen Ansprüche, umfassend je nach gewähltem Knopf eine andere Routine ausführen, abhängig davon, ob die dielektrische Tür (4) geöffnet oder geschlossen ist.

15. Verfahren gemäß einem der vorherigen Ansprüche, wobei die Anlage ein Weinkeller ist.

## Revendications

1. Appareil de refroidissement, de réchauffement ou de refroidissement et réchauffement, pour la préservation de boissons, d'aliments ou de matière biologique **caractérisé en ce qu'**il comprend:
un système de refroidissement et/ou un système de réchauffement;
une porte diélectrique (4) ; et
un dispositif de contrôle comprenant un ou plusieurs éléments sensibles capacitifs pour détecter le contact de l'utilisateur de l'appareil ; un ou plusieurs capteurs physiques pour quantifier les paramètres physiques liés à l'appareil ; un circuit électronique (1) pour lire les éléments sensibles capacitifs et contrôler l'appareil ; et des moyens de détection pour détecter si la porte diélectrique (4) est ouverte ou fermée ;
dans lequel l'élément ou les éléments sensible(s) capacitif(s) sont arrangés pour détecter directement le contact de l'utilisateur lorsque la porte diélectrique (4) est ouverte, et sont arrangés de façon à détecter le contact de l'utilisateur à travers la porte diélectrique (4) lorsque la porte diélectrique(4) est fermée; et dans lequel le dispositif de contrôle est configuré de façon à calibrer la valeur seuil de détection du contact dans les éléments sensibles capacitifs selon que la porte diélectrique (4) soit ouverte ou fermée.

2. Appareil selon la revendication précédente dans lequel le dispositif de contrôle est configuré pour calibrer la valeur seuil de détection de contact dans les éléments sensibles capacitifs :
lors de la mise en route initiale du circuit de contrôle (1) ; et
lorsqu'un changement de capacité électrique a lieu dans deux éléments sensibles capacitifs ou plus.

3. Appareil selon l'une quelconque des revendications antérieures dans lequel le dispositif de contrôle est configuré pour :
calibrer la capacité de référence des éléments sensibles capacitifs et la valeur seuil de détection de contact dans les éléments sensibles capacitifs : lors de la mise en route initiale du circuit de contrôle (1) ;
et lorsqu'un changement de capacité électrique a lieu dans deux éléments sensibles capacitifs ou plus ; et
exécuter une routine liée à un bouton sélectionné au moment du changement de capacité électrique sur un seul élément sensible capacitif, celui-ci étant l'élément sensible capacitif correspondant au bouton sélectionné.

4. Appareil selon l'une quelconque des revendications antérieures, dans lequel les élément sensible capacitifs sont des électrodes qui sont flexibles pour établir un contact direct en compression avec la porte diélectrique (4) lorsque celle-ci est en position fermée.

5. Appareil selon la revendication précédante, dans lequel les électrodes flexibles sont des ressorts.

6. Appareil selon l'une quelconque des revendications antérieures dans lequel le dispositif de contrôle est configuré pour sélectionner une routine différente devant être exécutée à travers un bouton sélectionné selon que la porte diélectrique (4) soit ouverte ou fermée.

7. Appareil selon l'une quelconque des revendications antérieures, dans lequel les capteurs physiques comprennent un capteur pour mesurer la température et le degré d'humidité.

8. Appareil selon l'une quelconque des revendications antérieures comprenant une structure en plastique injecté (3) pour soutenir le dispositif de contrôle en forme de parallelepipède et comprenant trois régions distinctes :
une région centrale pour accomoder l'interface utilisateur;
une région latérale de ladite interface pour accomoder les éléments sensibles capacitifs pour l'intéraction et le contrôle ; et
une région environnante pour la fixation et la ventilation de tous les composants électroniques, pour une accomodation sur le haut du corps principal de l'appareil.

9. Appareil selon l'une quelconque des revendications précédentes dans lequel le circuit électronique comprend un circuit de contrôle (1)
pour traiter des données, interpréter et programmer le circuit de lecture, et contrôler les éléments d'actionnement de l'appareil de refroidissement et/ou de réchauffement; et un circuit de lecture pour lire les signaux électriques des éléments sensibles capacitifs et envoyer les données respectives pour un traitement ultérieur.

10. Appareil selon l'une quelconque des revendications précédentes dans lequel l'appareil est une cave à vin.

11. Méthode pour opérer un appareil de refroidissement, de réchauffement, ou de refroidissement et réchauffement, pour la préservation de boissons, d'aliments ou de matière biologique, dans laquelle l'appareil comprend :
un système de refroidissement et/ou de réchauffement;
une porte diélectrique (4) ; et
un dispositif de contrôle comprenant un ou plusieurs éléments sensibles capacitifs pour détecter le contact de l'utilisateur de l'appareil ; un ou plusieurs capteurs pour quantifier les paramètres physiques liés à l'appareil ; un circuit électronique (1) pour lire les éléments sensibles capacitifs et contrôler l'appareil ; et des moyens de détection pour détecter si la porte diélectrique (4) est ouverte ou fermée ;
dans laquelle le ou les élément(s) sensible(s) capacitif(s) sont arrangés pour détecter directement le contact de l'utilisateur lorsque la porte diélectrique (4) est ouverte, et sont arrangés de façon à détecter le contact de l'utilisateur à travers la porte diélectrique (4) lorsque la porte diélectrique (4) est fermée ; **caractérisée en ce que** la méthode comprend également calibrer la valeur seuil de détection de contact dans les éléments sensibles capacitifs selon que la porte diélectrique (4) soit ouverte ou fermée.

12. Méthode selon la revendication précédente comprenant calibrer la valeur seuil de détection du contact dans les éléments sensibles capacitifs :
lors de la mise en route initiale du circuit de contrôle (1) ; et
lorsqu'un changement de capacité électrique a lieu dans deux éléments sensibles capacitifs ou plus.

13. Méthode selon l'une quelconque des revendications 11-12 comprenant :
calibrer la capacité de référence des éléments sensibles capacitifs et la valeur seuil de détection de contact dans les éléments sensibles capacitifs : lors de la mise en route initiale du circuit de contrôle (1) ;
et lorsqu'un changement de capacité électrique a lieu dans deux éléments de détection capacitifs ou plus ; et
executer une routine liée à un bouton sélectionné lors d'un changement de capacité électrique dans un unique élément sensible capacitif, celui-ci étant l'élément sensible capacitif correspondant au bouton sélectionné.

14. Méthode selon l'une quelconque des revendications antérieures comprenant la sélection d'une routine différente à exécuter liée à un bouton sélectionné selon que la porte diélectrique (4) soit ouverte ou fermée.

15. Méthode selon l'une quelconque des revendications antérieures dans laquelle l'appareil est une cave à vin.
